# EUROPEAN PATENT APPLICATION

(11) **EP 4 379 809 A1**
(43) Date of publication of application: **05.06.2024**
(21) Application number: 22866189.8
(22) Date of filing: 15.06.2022
(51) Int. Cl.: H01L 29/423, H01L 29/778, H01L 29/66

(54) **FIELD EFFECT TRANSISTOR, MANUFACTURING METHOD THEREFOR, AND ELECTRONIC CIRCUIT**

(30) Priority: 10.09.2021 CN 202111062320
(71) Applicant: Huawei Technologies Co., Ltd., Shenzhen, Guangdong 518129 (CN)
(72) Inventor: YI, Hongsheng, Shenzhen, Guangdong 518129 (CN); SUN, Hui, Shenzhen, Guangdong 518129 (CN); HU, Haolin, Shenzhen, Guangdong 518129 (CN); GAO, Biao, Shenzhen, Guangdong 518129 (CN)
(74) Representative: Isarpatent
(86) International application number: PCT/CN2022/098891
(87) International publication number: WO 2023/035714

(57) **Abstract**

This application provides a field effect transistor, a preparation method thereof, and an electronic circuit. During preparation, after a channel layer, a control gate layer, a metal gate layer, a hard mask layer, and a photoresist layer are sequentially formed on a substrate, a first photoresist mask pattern is formed. Dry etching is performed on the hard mask layer, to form a first hard mask pattern. Size shrinkage treatment is performed on the first photoresist mask pattern, to form a second photoresist mask pattern. A part, exposing the first hard mask pattern, of the second photoresist mask pattern forms a step surface. Dry etching is sequentially performed on the first hard mask pattern, the metal gate layer, and the control gate layer. During dry etching, the step surface extends downward and stops on a side wall of a control gate. The step surface may improve electrical leakage from the side wall. A stepped gate structure is prepared by using a single mask patterning process, so that process complexity and industrial costs are reduced. The step surface is formed by using only dry etching, so that etching damage is reduced.

## Description

### CROSS-REFERENCE TO RELATED APPLICATIONS

This application claims priority to Chinese Patent Application No. 202111062320.6, filed with the China National Intellectual Property Administration on September 10, 2021 and entitled "FIELD EFFECT TRANSISTOR, PREPARATION METHOD THEREOF, AND ELECTRONIC CIRCUIT", which is incorporated herein by reference in its entirety.

### TECHNICAL FIELD

This application relates to the field of semiconductor technologies, and in particular, to a field effect transistor, a preparation method thereof, and an electronic circuit.

### BACKGROUND

Gallium nitride (GaN) has advantages such as a large band gap and high mobility. Therefore, GaN is widely used in substrate materials in the field of power devices, and is most widely used in high electron mobility transistors (High Electron Mobility Transistors, HEMTs). In an HEMT device, a stacked structure of a metal gate (including a single layer such as TiN/W/Ni or stacking of one or more of TiN/W/Ni) and a control gate (including pGaN) is a most common stacked gate structure (which may also be referred to as a gate structure). When the device of this structure works, there is an electrical leakage channel between side walls of the metal gate and the control gate, affecting an electrical parameter such as gate leakage (gate leakage, Igleak).

At present, a method for laterally etching a metal gate by using a hard mask (hard mask) and a wet method, a spacer (spacer) etching method, or a triple mask patterning process is generally used in the industry, to shrink a size of the metal gate inward to form a stepped structure with the control gate below the metal gate, so that the channel between the side walls of the metal gate and the control gate is disconnected and electrical leakage is improved. However, the method for laterally etching a metal gate by using a hard mask and a wet method is poor in process stability. In the spacer etching method and the triple mask patterning process, etching damage may be brought to the control gate, resulting in a larger leakage current. In addition, the triple mask patterning process is complex, and requires high manufacturing costs.

### SUMMARY

This application provides a field effect transistor, a preparation method thereof, and an electronic circuit, to improve problems of electrical leakage in a gate structure of the field effect transistor and high process costs.

According to a first aspect, this application provides a gate structure of a field effect transistor, including a control gate located on a channel layer of the field effect transistor, and a metal gate located on the control gate. The control gate has a top surface and a side wall connected to the top surface. The side wall has a step surface parallel to the top surface. An orthographic projection of the metal gate on the channel layer falls within a region in which an orthographic projection of the top surface on the channel layer is located. Specifically, the channel layer is configured as a functional layer of the field effect transistor to form a two-dimensional electron gas of the field effect transistor. The channel layer may include a GaN layer and an AlGaN barrier layer that are stacked. The GaN layer is located between the AlGaN barrier layer and a substrate. A channel may be formed on a contact surface between the GaN layer and the AlGaN barrier layer. The two-dimensional electron gas is located on the contact surface between the GaN layer and the AlGaN barrier layer. A source and a drain of the field effect transistor may form ohmic contact with the GaN layer. When the gate structure controls the channel to be connected, electrons are located in the channel, and the source and the drain may be conducted by using the electrons in the channel. When the gate structure controls the channel to be disconnected, there is no free electron in the channel, and the source and the drain are cut off. In the gate structure of the field effect transistor provided in this embodiment of this application, the step surface used to block a channel between side walls is formed on the side wall of the control gate. The step surface formed through inward shrinkage of the side wall of the control gate may improve electrical leakage between the side walls of the metal gate and the control electrode. In comparison with a gate structure in the conventional technology in which a step surface used to block a channel between side walls is located on an interface between a control gate and a metal gate, in a process of forming the gate structure provided in this application, the step surface is controlled to be located on the side wall of the control gate, and patterns of the control electrode and the metal gate may be formed by using a single mask patterning process, so that process complexity and industrial costs are reduced. In addition, dry etching may be used in a process of forming the step surface, so that etching damage is reduced.

In a possible implementation of this application, a width of the step surface is generally greater than 50 nm, so that the step surface may effectively block electrical leakage through the channel between the side walls.

In a possible implementation of this application, a size of the step surface may be controlled by matching a thickness of each film layer, a shrinkage size of photoresist, and a dry etching depth, so that a ratio of a height of the step surface to a thickness of the control gate is any value from 0 to 1. In this way, the step surface may stop at any position as required on the side wall of the control gate, to obtain stepped gate structures of different sizes.

In a possible implementation of this application, the gate structure further includes a hard mask located on the metal gate, and an orthographic projection of the hard mask on the channel layer falls within a region in which the orthographic projection of the metal gate on the channel layer is located.

According to a second aspect, this application provides a field effect transistor, including a channel layer located on a substrate, a control gate located on the channel layer, a metal gate located on the control gate, a passivation layer located on the metal gate and covering the control gate and the metal gate, and a source and a drain located on the channel layer. The source and the drain are respectively located on two sides of the control gate. The control gate has a top surface and a side wall connected to the top surface. The side wall has a step surface parallel to the top surface. An orthographic projection of the metal gate on the substrate falls within a region in which an orthographic projection of the top surface on the substrate is located. Specifically, the channel layer is configured as a functional layer of the field effect transistor to form a two-dimensional electron gas of the field effect transistor. The channel layer may include a GaN layer and an AlGaN barrier layer that are stacked. The GaN layer is located between the AlGaN barrier layer and the substrate. A channel may be formed on a contact surface between the GaN layer and the AlGaN barrier layer. The two-dimensional electron gas is located on the contact surface between the GaN layer and the AlGaN barrier layer. The source and the drain of the field effect transistor may form ohmic contact with the GaN layer. When the gate structure controls the channel to be connected, electrons are located in the channel, and the source and the drain may be conducted by using the electrons in the channel. When the gate structure controls the channel to be disconnected, there is no free electron in the channel, and the source and the drain are cut off.

In the field effect transistor provided in this embodiment of this application, the step surface used to block a channel between side walls is formed on the side wall of the control gate. The step surface formed through inward shrinkage of the side wall of the control gate may improve electrical leakage between the side walls of the metal gate and the control electrode. In comparison with a gate structure in the conventional technology in which a step surface used to block a channel between side walls is located on an interface between a control gate and a metal gate, in a process of forming the field effect transistor provided in this application, the step surface is controlled to be located on the side wall of the control gate, and patterns of the control electrode and the metal gate may be formed by using a single mask patterning process, so that process complexity and industrial costs are reduced. In addition, dry etching may be used in a process of forming the step surface, so that etching damage is reduced.

In a possible implementation of this application, a width of the step surface is generally greater than 50 nm, so that the step surface may effectively block electrical leakage through the channel between the side walls.

In a possible implementation of this application, a size of the step surface may be controlled by matching a thickness of each film layer, a shrinkage size of photoresist, and a dry etching depth, so that a ratio of a height of the step surface to a thickness of the control gate is any value from 0 to 1. In this way, the step surface may stop at any position as required on the side wall of the control gate, to obtain stepped gate structures of different sizes.

In a possible implementation of this application, the field effect transistor further includes a hard mask located between the metal gate and the passivation layer, and an orthographic projection of the hard mask on the substrate falls within a region in which the orthographic projection of the metal gate on the substrate is located.

According to a third aspect, this application provides an electronic circuit. The electronic circuit includes a circuit board and the field effect transistor that is disposed on the circuit board and that is provided in each implementation of the second aspect of this application.

According to a fourth aspect, this application provides a method for preparing a field effect transistor, including: first, sequentially forming a channel layer, a control gate layer, a metal gate layer, a hard mask layer, and a photoresist layer on a substrate; then, patterning the photoresist layer by using a mask, to form a first photoresist mask pattern; next, performing dry etching on the hard mask layer under occlusion of the first photoresist mask pattern, to form a first hard mask pattern; later on, performing size shrinkage treatment on the first photoresist mask pattern, to form a second photoresist mask pattern, where a part, exposing the first hard mask pattern, of the second photoresist mask pattern forms a step surface; and finally, sequentially performing dry etching on the first hard mask pattern, the metal gate layer, and the control gate layer under occlusion of the second photoresist mask pattern, to form a second hard mask pattern, a metal gate, and a control gate. Orthographic projections of the second hard mask pattern and the metal gate on the substrate fall within a region in which an orthographic projection of a top surface of the control gate on the substrate is located. In a dry etching process, the step surface extends downward and stops on a side wall of the control gate.

In a field effect transistor prepared by using the preparation method provided in this embodiment of this application, the step surface used to block a channel between side walls is formed on the side wall of the control gate. The step surface formed through inward shrinkage of the side wall of the control gate may improve electrical leakage between the side walls of the metal gate and the control electrode. According to the preparation method in this application, a stepped gate structure may be prepared by using a single mask (mask) patterning process, so that process complexity and industrial costs are reduced. In addition, in comparison with a gate structure in the conventional technology in which a step surface used to block a channel between side walls is located on an interface between a control gate and a metal gate, only dry etching is used in a process of forming the step surface, so that etching damage is reduced.

In a possible implementation of this application, the preparation method may further include: removing the second photoresist mask pattern and the second hard mask pattern.

In a possible implementation of this application, secondary patterning (also referred to as secondary exposure and development) may be performed on the first photoresist mask pattern by using an original mask (also referred to as an original photomask), or ashing treatment (also referred to as a dry stripping manner) is performed on the first photoresist mask pattern, to shrink a size of the first photoresist mask pattern to form the second photoresist mask pattern.

In a possible implementation of this application, after size shrinkage treatment is performed on the first photoresist mask pattern, a thickness of the obtained second photoresist mask pattern needs to be greater than 0.1 µm, to meet a minimum requirement of using the second photoresist mask pattern as a mask pattern in a subsequent etching process.

In a possible implementation of this application, after dry etching is performed on the hard mask layer under occlusion of the first photoresist mask pattern to form the first hard mask pattern, the control gate layer may be further etched.

In a possible implementation of this application, a width of the step surface is generally greater than 50 nm, so that the step surface may effectively block electrical leakage through the channel between the side walls.

In a possible implementation of this application, a size of the step surface may be controlled by matching a thickness of each film layer, a shrinkage size of photoresist, and a dry etching depth, so that a ratio of a height of the step surface to a thickness of the control gate is any value from 0 to 1. In this way, the step surface may stop at any position as required on the side wall of the control gate, to obtain stepped gate structures of different sizes.

### BRIEF DESCRIPTION OF DRAWINGS

FIG. 1 is a schematic diagram of a structure after each step in a preparation process of a method for laterally etching a metal gate by using a hard mask and a wet method is completed;
FIG. 2 is a schematic diagram of a structure after each step in a process of preparing a stepped gate structure by using a spacer etching method is completed;
FIG. 3A and FIG. 3B are schematic diagrams of a structure after each step in a process of preparing a metal gate with size shrinkage by using a triple mask patterning process method is completed;
FIG. 4 is a schematic flowchart of a method for preparing a field effect transistor according to an embodiment of this application;
FIG. 5 is a schematic diagram of a structure after each step in a preparation method is completed according to an embodiment of this application;
FIG. 6 is a schematic diagram of another structure after each step in a preparation method is completed according to an embodiment of this application;
FIG. 7a is a schematic sectional view of a gate structure of a field effect transistor according to an embodiment of this application;
FIG. 7b is a schematic sectional view of a gate structure of another field effect transistor according to an embodiment of this application;
FIG. 7c is a schematic sectional view of a gate structure of another field effect transistor according to an embodiment of this application;
FIG. 7d is a schematic sectional view of a gate structure of another field effect transistor according to an embodiment of this application;
FIG. 8a is a schematic sectional view of a structure of a field effect transistor according to an embodiment of this application;
FIG. 8b is a schematic sectional view of a structure of another field effect transistor according to an embodiment of this application;
FIG. 8c is a schematic sectional view of a structure of another field effect transistor according to an embodiment of this application; and
FIG. 8d is a schematic sectional view of a structure of another field effect transistor according to an embodiment of this application.

### Reference numerals:

1-Substrate; 2-Buffer layer; 3-GaN layer; 31-Channel layer; 4-AlGaN layer; 5-Control gate layer; 51-Control gate; 51a-Top surface; 51b-Side wall; 51c-Step surface; 6-Metal gate layer; 61-Metal gate; 62-First intermediate metal gate pattern; 63-Second intermediate metal gate pattern; 7-Hard mask layer; 71-First hard mask pattern; 72-Second hard mask pattern; 8-Photoresist layer; 81-First photoresist mask pattern; 82-Second photoresist mask pattern; 9-Dielectric layer; 91-Dielectric; 10-Passivation layer; 11-Source; 12-Drain.

### DESCRIPTION OF EMBODIMENTS

To make objectives, technical solutions, and advantages of this application clearer, the following further describes this application in detail with reference to the accompanying drawings.

An AlGaN/GaN heterojunction HEMT structure based on a GaN material has excellent characteristics such as high electron mobility, high 2DEG surface density, high chemical stability, a high frequency, and high power, so that a device made of the GaN material has obvious advantages in both of the radio frequency field and the power electronics field. Therefore, a field effect transistor provided in embodiments of this application may be widely used as a component of an electronic circuit in various scenarios. For example, the field effect transistor is widely used in a 5th generation mobile communication technology (5th generation wireless communication technology, 5G) wireless communication base station, a power electronic component, and the like in the fields of information receiving and sending, energy conversion, high-frequency switches, and the like.

In an HEMT device, a stacked structure of a metal gate and a control gate is a most common stacked gate structure. When the device of this structure works, there is an electrical leakage channel between side walls of the metal gate and the control gate, affecting an electrical parameter such as gate leakage. At present, a method for laterally etching a metal gate by using a hard mask (hard mask) and a wet method, or a spacer (spacer) etching method is generally used in the industry, to shrink a size of the metal gate inward to form a stepped structure with the control gate below the metal gate, so that the channel between the side walls of the metal gate and the control gate is disconnected and electrical leakage is improved.

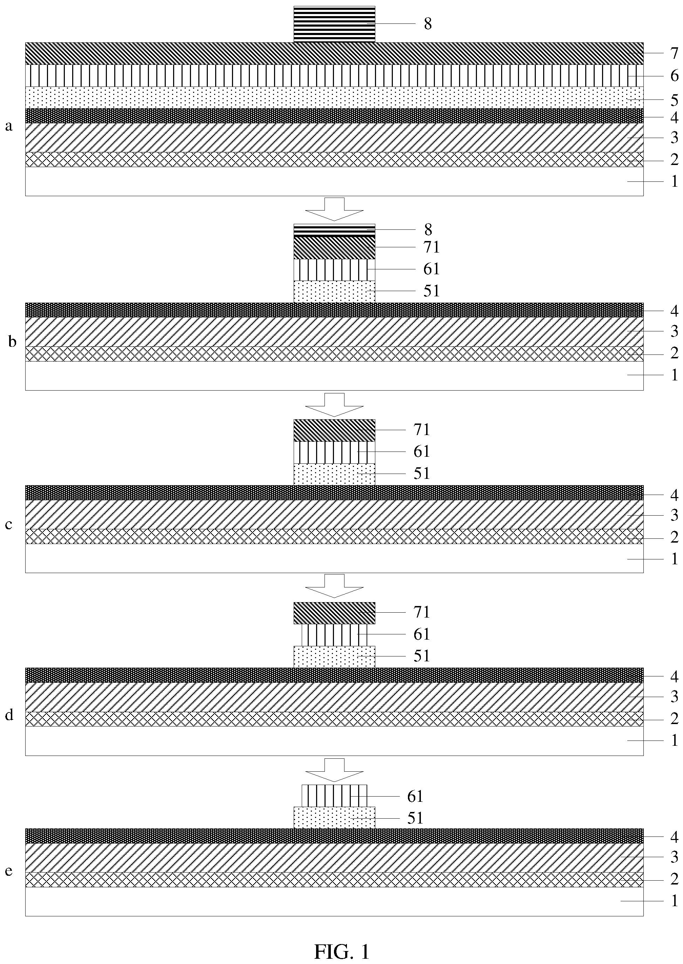

Refer to FIG. 1. A process flow of a currently commonly used method for laterally etching a metal gate by using a hard mask and a wet method includes: with reference to a in FIG. 1, performing gate photoetching after a metal gate layer 6, a hard mask layer 7, and a photoresist layer 8 are grown on a surface of a wafer including a substrate 1, a buffer layer 2, a GaN layer 3, an AlGaN layer 4, and a pGaN layer, that is, a control gate layer 5, that are sequentially stacked; refer to b in FIG. 1, sequentially etching the hard mask layer 7, the metal gate layer 6, and the control gate layer 5 to obtain a first hard mask pattern 71, a pattern of a metal gate 61, and a pattern of a control gate 51; refer to c in FIG. 1, removing the photoresist layer 8; refer to d in FIG. 1, shrinking the metal gate 61 inward by using a method for laterally etching a metal gate by using a wet method, to block an electrical leakage channel between side walls of the metal gate 61 and the control gate 51; and refer to e in FIG. 1, removing the first hard mask pattern 71. Because a thin metamorphic layer is easily formed on the side wall of the metal gate 61 during wet etching and removing of photoresist, and wet etching has a load effect, the metal gate 61 has an abnormality that the side wall is sawtooth-shaped during inward shrinkage, and lateral etching depths of the pattern of the metal gate 61 in different sizes are different. In addition, an undercut (undercut) is easily formed in wet etching, so that a subsequent film deposition process is affected. Therefore, a stepped metal gate structure prepared by using the method for laterally etching a metal gate by using a hard mask and a wet method is poor in both shape and process stability.

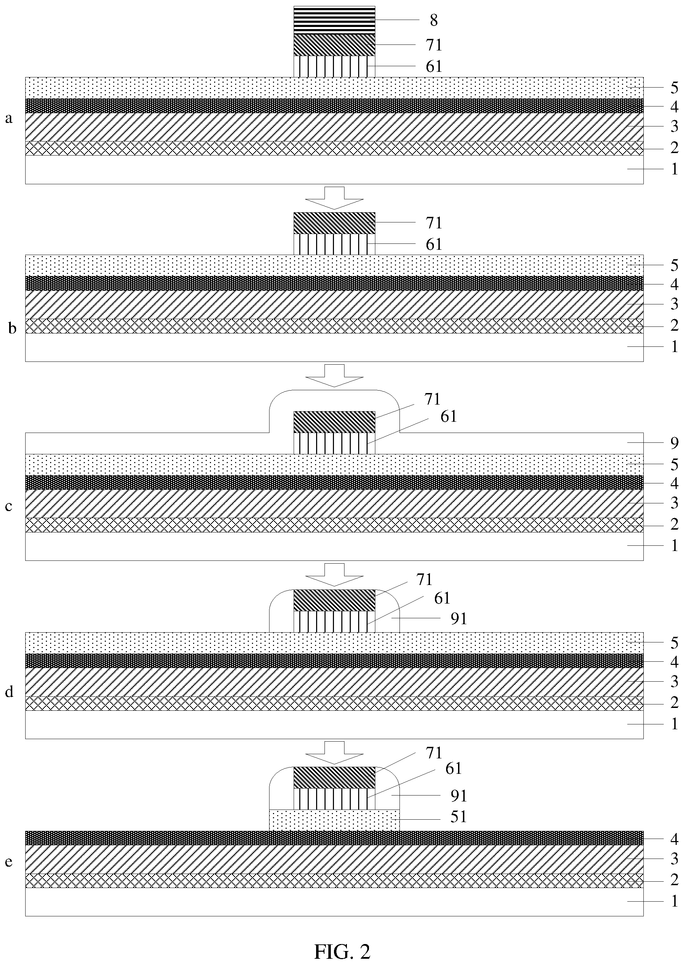

Refer to FIG. 2. A current process flow of preparing a stepped gate structure by using a spacer etching method includes: performing gate photoetching after a metal gate layer 6, a hard mask layer 7, and a photoresist layer 8 are grown on a surface of a wafer including a substrate 1, a buffer layer 2, a GaN layer 3, an AlGaN layer 4, and a pGaN layer, that is, a control gate layer 5, that are sequentially stacked; with reference to a in FIG. 2, sequentially etching the hard mask layer 7 and the metal gate layer 6 to form a first hard mask pattern 71 and a metal gate 61; with reference to b in FIG. 2, removing the photoresist layer 8; with reference to c in FIG. 2, depositing a dielectric layer 9 as a barrier sacrificial layer; with reference to d in FIG. 2, etching the dielectric layer 9 in a large area by using the spacer etching method, where a dielectric 91 on two sides of the metal gate 61 is reserved due to etching anisotropy; with reference to e in FIG. 2, etching the control gate layer 5, where the reserved dielectric 91 may define, as a mask (mask), a line width of a control gate 51 that is larger than a line width of the metal gate 61, so that a stepped gate structure of the metal gate 61 and the control gate 51 is implemented; and finally, removing the first hard mask pattern 71 and the dielectric 91. Compared with the method for laterally etching a metal gate by using a hard mask and a wet method, depositing the dielectric layer and the spacer etching method have better uniformity and stability of a film layer. Therefore, a stepped gate structure in which the metal gate 61 has a flat side wall shape and a uniform inward shrinkage depth may be obtained. However, in an over-etching step in which the metal gate is etched, a surface of the control gate layer 5 may be damaged, finally bringing etching damage to a part that is of the control gate 51 and that extends out of the metal gate 61. As a result, a leakage current increases.

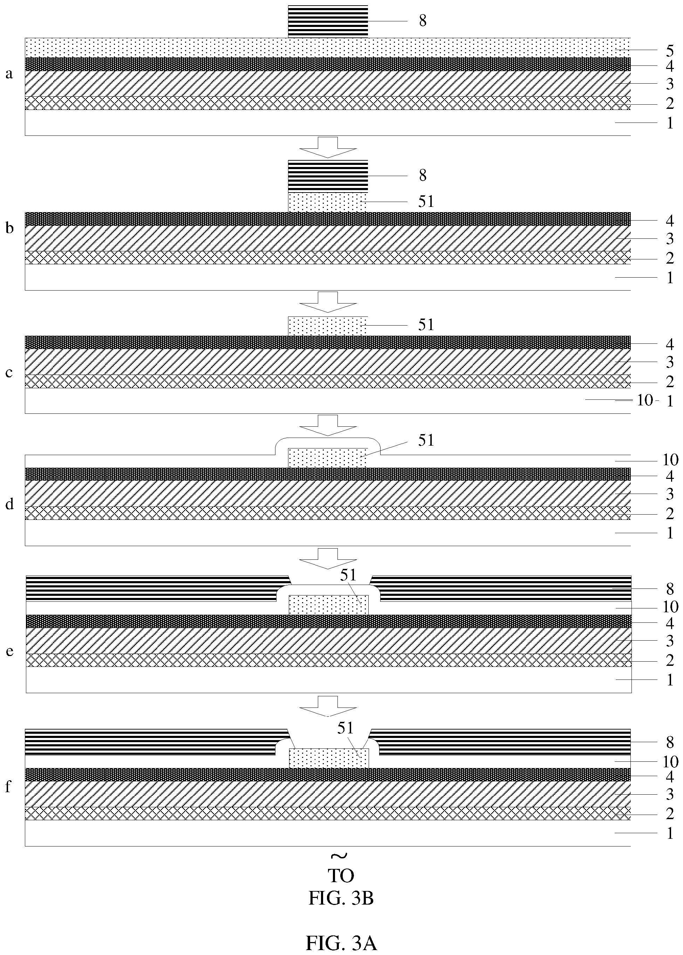

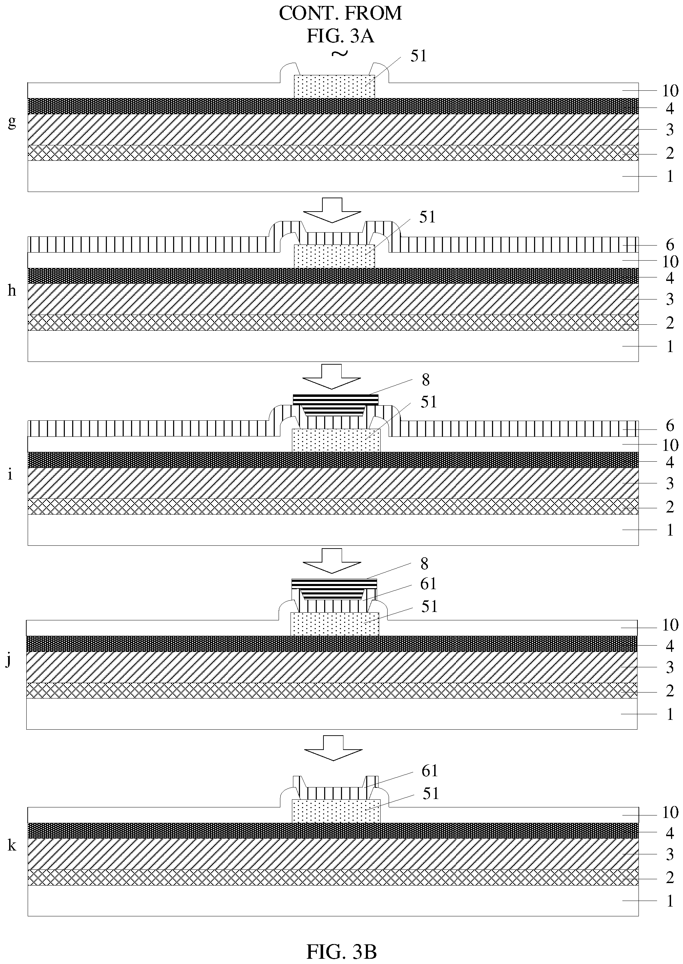

Refer to FIG. 3A and FIG. 3B. A current process flow of preparing a metal gate with size shrinkage by using a triple mask (mask) patterning process method includes: with reference to a to c in FIG. 3A, etching, on a wafer including a substrate 1, a buffer layer 2, a GaN layer 3, an AlGaN layer 4, and a pGaN layer 5 that are sequentially stacked, a pattern of a control gate 51 by using a first mask; with reference to d to g in FIG. 3A and 3B, after a passivation layer 10 is grown, forming a hole of a small size by using a second mask through etching; and with reference to h to k in FIG. 3B, depositing a metal gate layer 6, and forming a reserved metal gate 61 by using a third mask through etching. In this case, a size shrinkage of the finally formed metal gate is determined based on design sizes of the three masks and process engraving precision. Compared with the foregoing two methods, process controllability of the triple mask patterning process is greatly enhanced. Shrunk structures and asymmetric structures of different sizes may be obtained by changing a layout design. However, when the passivation layer 10 is punched, a surface of the control gate 51 is damaged, affecting an ion channel. In addition, process complexity and costs of the triple mask method are greatly increased.

In view of this, embodiments of this application provide a gate structure of a field effect transistor, a preparation method thereof, a field effect transistor, and an electronic circuit, to improve problems of gate leakage and high process costs. The following describes the gate structure, the preparation method thereof, the field effect transistor, and the electronic circuit in detail with reference to specific accompanying drawings and embodiments.

Terms used in the following embodiments are merely for the purpose of describing specific embodiments, but are not intended to limit this application. As used in the specification of this application and the appended claims, the singular expression "a", "an", "the", "the foregoing", "such a", or "this" is intended to also include an expression such as "one or more", unless otherwise clearly indicated in the context.

Reference to "an embodiment", "some embodiments", or the like described in this specification indicates that one or more embodiments of this application include a specific feature, structure, or characteristic described with reference to those embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

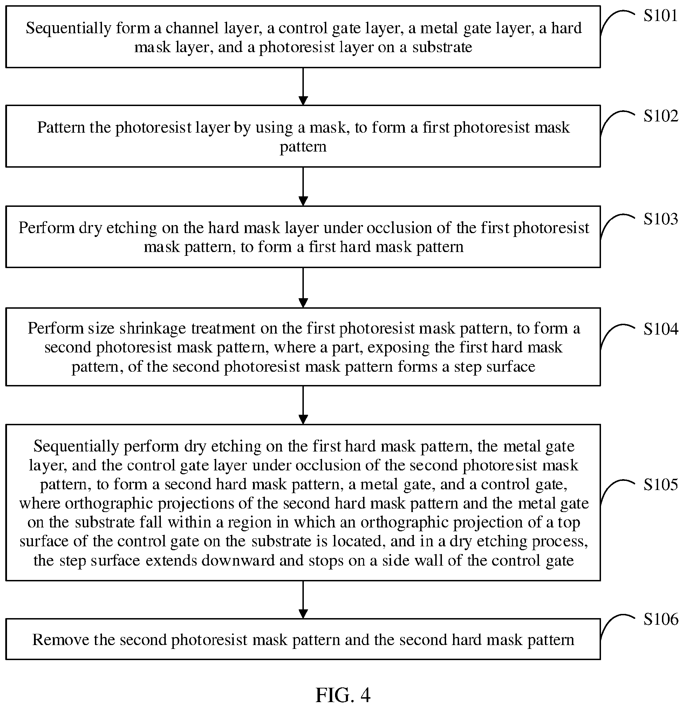

FIG. 4 shows an example of a schematic flowchart of a method for preparing a field effect transistor according to an embodiment of this application. Refer to FIG. 4. In an embodiment of this application, the preparation method mainly includes the following steps.

S101: Sequentially form a channel layer, a control gate layer, a metal gate layer, a hard mask layer, and a photoresist layer on a substrate.

S102: Pattern the photoresist layer by using a mask, to form a first photoresist mask pattern.

S 103: Perform dry etching on the hard mask layer under occlusion of the first photoresist mask pattern, to form a first hard mask pattern.

S104: Perform size shrinkage treatment on the first photoresist mask pattern, to form a second photoresist mask pattern, where a part, exposing the first hard mask pattern, of the second photoresist mask pattern forms a step surface.

S105: Sequentially perform dry etching on the first hard mask pattern, the metal gate layer, and the control gate layer under occlusion of the second photoresist mask pattern, to form a second hard mask pattern, a metal gate, and a control gate, where orthographic projections of the second hard mask pattern and the metal gate on the substrate fall within a region in which an orthographic projection of a top surface of the control gate on the substrate is located, and in a dry etching process, the step surface extends downward and stops on a side wall of the control gate.

In a field effect transistor prepared by using the preparation method provided in this embodiment of this application, the step surface used to block a channel between side walls is formed on the side wall of the control gate. The step surface formed through inward shrinkage of the side wall of the control gate may improve electrical leakage between the side walls of the metal gate and the control electrode. According to the preparation method in this application, a stepped gate structure may be prepared by using a single mask (mask) patterning process, so that process complexity and industrial costs are reduced. In addition, compared with a gate structure in the conventional technology in which a step surface used to block a channel between side walls is located on an interface between a control gate and a metal gate, only dry etching is used in a process of forming the step surface, so that etching damage is reduced.

Still refer to FIG. 4. In this embodiment of this application, the preparation method may further include the following step.

S106: Remove the second photoresist mask pattern and the second hard mask pattern.

In addition, a passivation layer covering the metal gate and the control gate may be further formed subsequently, and a source and a drain that are respectively located on two sides of the control gate are formed on the channel layer.

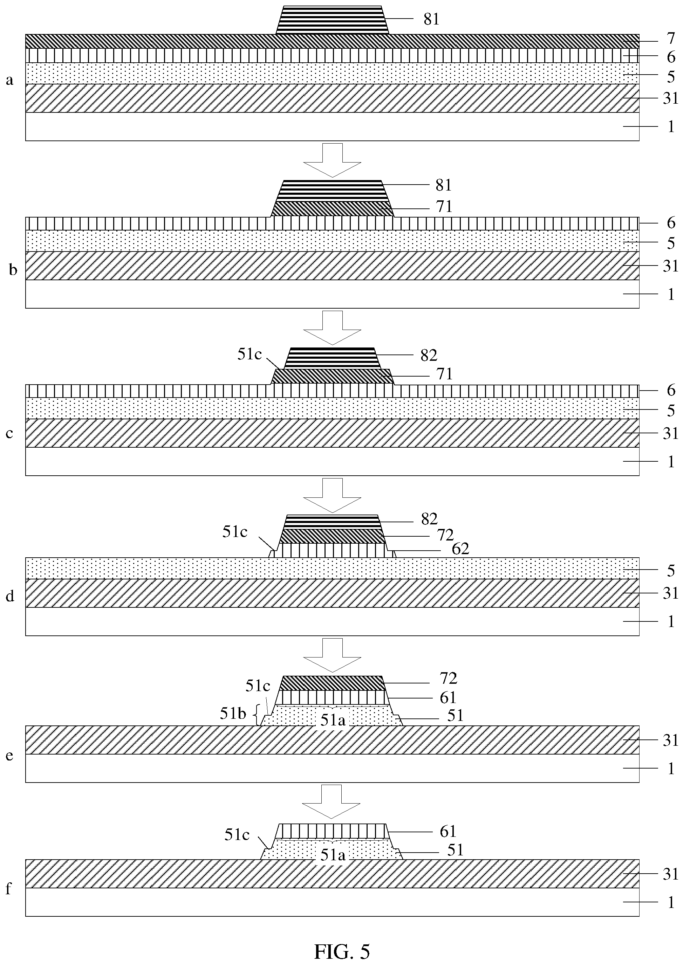

The following describes in detail the preparation method provided in this embodiment of this application with reference to the accompanying drawings. FIG. 5 shows an example of a schematic diagram of a structure after each step in a preparation process is completed. Refer to FIG. 5. In this embodiment of this application, the preparation method includes the following steps.
1: With reference to a in FIG. 5, sequentially form a channel layer 31, a control gate layer 5, a metal gate layer 6, a hard mask layer 7, and a photoresist layer on a substrate 1, and after exposure and development are performed on the photoresist layer by using a mask (also referred to as a photomask), remove redundant photoresist to form a first photoresist mask pattern 81.

Specifically, the substrate 1 may be prepared from a semiconductor material such as an III-V compound, silicon, sapphire, or silicon carbide. The channel layer 31 is configured as a functional layer of a field effect transistor to form a two-dimensional electron gas of the field effect transistor. The channel layer 31 may include a GaN layer and an AlGaN barrier layer that are stacked. The GaN layer is located between the AlGaN barrier layer and the substrate 1. A channel may be formed on a contact surface between the GaN layer and the AlGaN barrier layer. The two-dimensional electron gas is located on the contact surface between the GaN layer and the AlGaN barrier layer. A source and a drain of the field effect transistor may form ohmic contact with the GaN layer. When a gate structure controls the channel to be connected, electrons are located in the channel, and the source and the drain may be conducted by using the electrons in the channel. When a gate structure controls the channel to be disconnected, there is no free electron in the channel, and the source and the drain are cut off.

In an optional solution, before the channel layer 31 is formed on the substrate 1, a buffer layer may be further formed on the substrate 1. The buffer layer may be specifically formed on a surface of the substrate 1 by using processes such as chemical vapor deposition and epitaxial growth. The buffer layer serves as an optional structural layer. The buffer layer may be disposed based on a requirement. For example, when the substrate 1 can directly carry the channel layer 31, no buffer layer may be disposed, and the channel layer 31 may be directly formed on the substrate 1. When the channel layer 31 conflicts with a material of the substrate 1, and the channel layer 31 cannot be directly formed on the substrate 1, the buffer layer is disposed to isolate the substrate 1 from the channel layer 31. A material of the buffer layer needs to be selected based on the material of the substrate 1. This is not limited herein.

Specifically, a material of the control gate layer 5 may include pGaN. A material of the metal gate layer 6 includes but is not limited to a metal or a metal compound such as TiN, W, Ta, TaN, Pd or WSi. A material of the hard mask layer 7 includes but is not limited to SiO2, Si3N4, AlO, AlN, and the like.

2: With reference to b in FIG. 5, perform dry etching on the hard mask layer 7 under occlusion of the first photoresist mask pattern 81, to expose the metal gate layer 6 to form a first hard mask pattern 71.

Specifically, an over-etching process may be used in an etching process, so that an opening region stops on a surface of the metal gate layer 6. After etching is completed, wet cleaning may be performed to remove an etching residue.

3: With reference to c in FIG. 5, perform secondary patterning (also referred to as secondary exposure and development) on the first photoresist mask pattern by using an original mask (also referred to as an original photomask), or perform ashing treatment (also referred to as a dry stripping manner) on the first photoresist mask pattern, to shrink a size of the first photoresist mask pattern to form a second photoresist mask pattern 82, where a part, exposing the first hard mask pattern 71, of the second photoresist mask pattern 82 forms a step surface 51c.

Specifically, when secondary exposure and development are performed by using the original photomask to shrink the size of the first photoresist mask pattern 81, a shrinkage size of the first photoresist mask pattern 81 may be controlled by adjusting a focal length/energy of an exposure machine.

Specifically, when ashing treatment is performed on the first photoresist mask pattern, a part of the first photoresist mask pattern may be removed by using a dry stripper (asher). When a thickness of the first photoresist mask pattern decreases, a width of the first photoresist mask pattern also shrinks inward.

Specifically, after size shrinkage treatment is performed on the first photoresist mask pattern, a thickness of the obtained second photoresist mask pattern 82 needs to be greater than 0.1 µm, to meet a minimum requirement of using the second photoresist mask pattern 82 as a mask pattern in a subsequent etching process.

Specifically, a part, exposed by the second photoresist mask pattern 82, of the first hard mask pattern 71 forms the step surface 51c, and a width a of the step surface 51c is preferably greater than 50 nm, so that electrical leakage through a channel between side walls may be effectively blocked by the step surface 51c that finally stops on the side wall of the control electrode subsequently.

4: With reference to d and e in FIG. 5, sequentially perform dry etching in an etcher on the first hard mask pattern 71, the metal gate layer 6, and the control gate layer 5 under occlusion of the second photoresist mask pattern 82, to form a second hard mask pattern 72, a metal gate 61, and a control gate 51, where orthographic projections of the second hard mask pattern 72 and the metal gate 61 on the substrate 1 approximately coincide with that of a top surface 51a of the control gate 51 on the substrate 1. In addition, in a dry etching process, with reference to d in FIG. 5, the step surface 51c passes through the metal gate layer 6 to form a first intermediate metal gate pattern 62 on the metal gate layer 6, and then the step surface 51c extends downward and finally stops on the side wall 51b of the control gate 51. Moreover, in the etching process, the second photoresist mask pattern 82 is slowly etched off, for example, d in FIG. 5. Therefore, the metal gate layer 6 and the control gate layer 5 are actually etched under occlusion of the second hard mask pattern 72.

5: With reference to f in FIG. 5, finally remove the remaining second photoresist mask pattern 82 and second hard mask pattern 72 by using a wet method, to obtain a final stepped gate structure, or reserve the second hard mask pattern 72. This is not limited herein.

In the preparation method provided in this application, a size of the step surface may be controlled by matching a thickness of each film layer, the shrinkage size of the first photoresist mask pattern 81, and a dry etching depth, so that the step surface 51c may stop at any position as required on the side wall 51b of the control gate 51, to obtain stepped gate structures of different sizes.

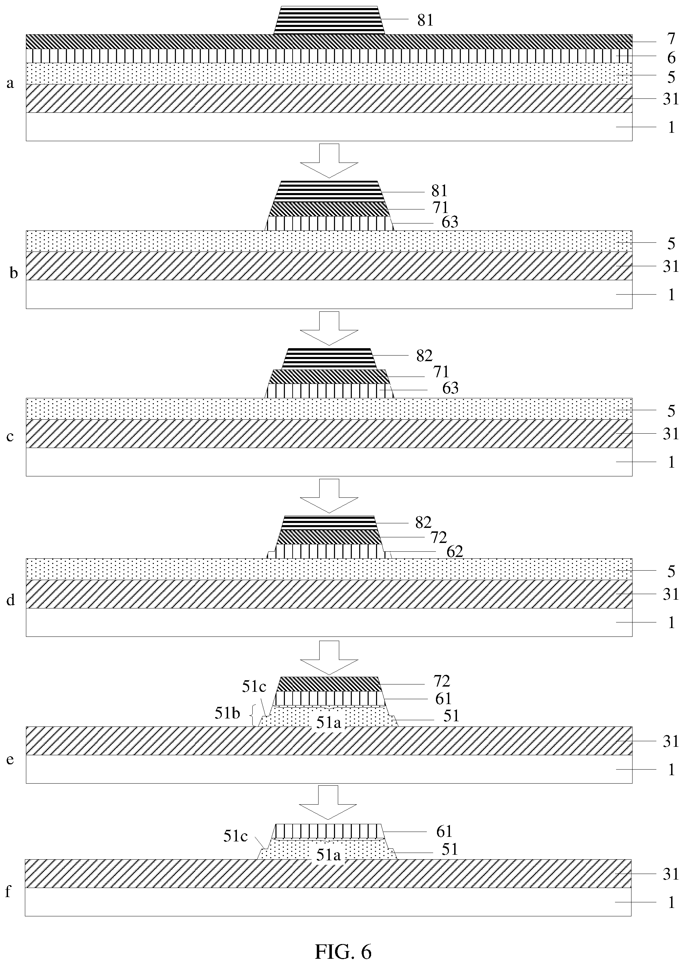

FIG. 6 shows an example of a schematic diagram of another structure after each step in a process of preparing a gate structure is completed. Refer to FIG. 6. In another embodiment of this application, the preparation method includes the following steps.
1: With reference to a in FIG. 6, sequentially form a channel layer 31, a control gate layer 5, a metal gate layer 6, a hard mask layer 7, and a photoresist layer on a substrate 1, and after exposure and development are performed on the photoresist layer by using a single mask (also referred to as a photomask), remove redundant photoresist to form a first photoresist mask pattern 81. A specific process and parameters are the same as those in a in FIG. 5, and details are not described herein again.
2: With reference to b in FIG. 6, perform dry etching on the hard mask layer 7 and the metal gate layer 6 under occlusion of the first photoresist mask pattern 81, to expose the control gate layer 5 to form a first hard mask pattern 71 and a second intermediate metal gate pattern 63.
   Specifically, a difference from the foregoing embodiment shown in FIG. 5 lies in that the control gate layer 5 is further etched after the hard mask layer 7 is etched. In addition, an over-etching process may be used in an etching process, so that an opening region stops on a surface of the control gate layer 5. After etching is completed, wet cleaning may be performed to remove an etching residue.
3: With reference to c in FIG. 6, perform secondary patterning (also referred to as secondary exposure and development) on the first photoresist mask pattern by using an original mask (also referred to as an original photomask), or perform ashing treatment (also referred to as a dry stripping manner) on the first photoresist mask pattern, to shrink a size of the first photoresist mask pattern to form a second photoresist mask pattern 82, where a part, exposing the first hard mask pattern 71, of the second photoresist mask pattern 82 forms a step surface 51c. A specific process and parameters are the same as those in c in FIG. 5, and details are not described herein again.
4: With reference to d and e in FIG. 6, sequentially perform dry etching in an etcher on the first hard mask pattern 71, the second intermediate metal gate pattern 63, and the control gate layer 5 under occlusion of the second photoresist mask pattern 82, to form a second hard mask pattern 72, a metal gate 61, and a control gate 51, where orthographic projections of the second hard mask pattern 72 and the metal gate 61 on the substrate 1 approximately coincide with that of a top surface 51a of the control gate 51 on the substrate 1. In addition, in a dry etching process, with reference to d in FIG. 6, the step surface 51c passes through the second intermediate metal gate pattern 63 to form a first intermediate metal gate pattern 62 on the second intermediate metal gate pattern 63, and then the step surface 51c extends downward and finally stops on a side wall 51b of the control gate 51. Moreover, in the etching process, the second photoresist mask pattern 82 is slowly etched off, for example, d in FIG. 6. Therefore, the second intermediate metal gate pattern 63 and the control gate layer 5 are actually etched under occlusion of the second hard mask pattern 72.
5: With reference to f in FIG. 6, finally remove the remaining second photoresist mask pattern 82 and second hard mask pattern 72 by using a wet method, to obtain a final stepped gate structure, or reserve the second hard mask pattern 72. This is not limited herein.

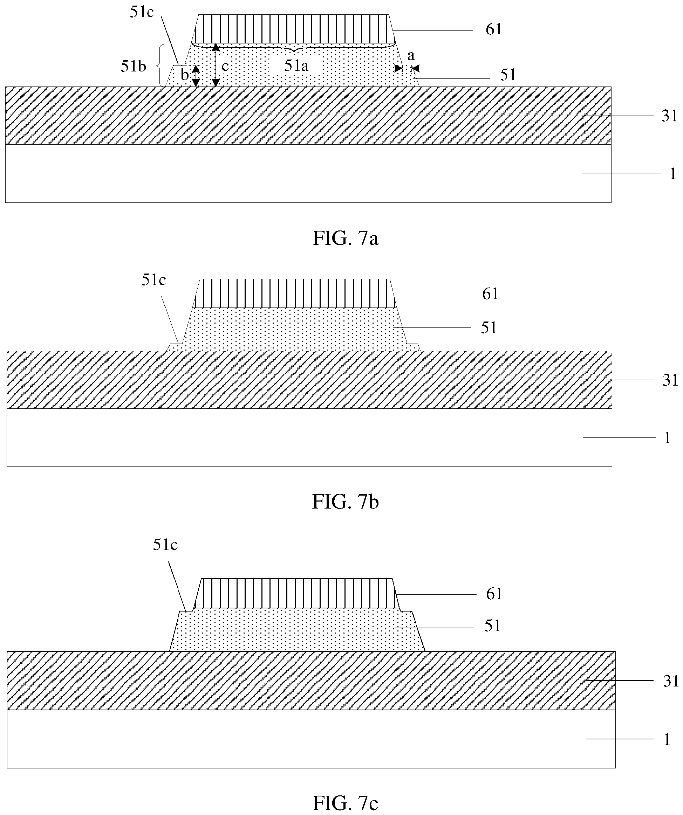

FIG. 7a to FIG. 7c show an example of a schematic sectional view of a gate structure of a field effect transistor according to an embodiment of this application. Refer to FIG. 7a to FIG. 7c. In an embodiment of this application, the gate structure of the field effect transistor may include a control gate 51 located on a channel layer 31 of the field effect transistor, and a metal gate 61 located on the control gate 51. The control gate 51 has a top surface 51a and a side wall 51b connected to the top surface 51a. The side wall 51b has a step surface 51c parallel to the top surface 51a. An orthographic projection of the metal gate 61 on the channel layer 31 falls within a region in which an orthographic projection of the top surface 51a on the channel layer 31 is located.

The gate structure of the field effect transistor provided in this embodiment of this application is prepared by using the foregoing preparation method. The step surface 51c used to block a channel between side walls is formed on the side wall 51b of the control gate 51. The step surface 51c formed through inward shrinkage of the side wall 51b of the control gate 51 may improve electrical leakage between the side walls of the metal gate 61 and the control electrode 51. In comparison with a gate structure in the conventional technology in which a step surface used to block a channel between side walls is located on an interface between a control gate and a metal gate, in a process of forming the gate structure provided in this application, the step surface 51c is controlled to be located on the side wall 51b of the control gate 51, and patterns of the control electrode 51 and the metal gate 61 may be formed by using a single mask patterning process, so that process complexity and industrial costs are reduced. In addition, dry etching may be used in a process of forming the step surface 51c, so that etching damage is reduced.

Still refer to FIG. 7a. In this embodiment of this application, a width a of the step surface 51c is generally greater than 50 nm, so that the step surface 51c may effectively block electrical leakage through the channel between the side walls.

Still refer to FIG. 7a to FIG. 7c. In this embodiment of this application, a size of the step surface 51c may be controlled by matching a thickness of each film layer, a shrinkage size of the first photoresist mask pattern 81, and a dry etching depth, so that a ratio of a height b of the step surface 51c to a thickness c of the control gate 51 is any value from 0 to 1. In this way, the step surface 51c may stop at any position as required on the side wall 51b of the control gate 51. For example, refer to FIG. 7a. The step surface 51c is located in the middle of the side wall 51b. Refer to FIG. 7b. The step surface 51c is located at the bottom of the side wall 51b. Refer to FIG. 7c. The step surface 51c is located at an upper part of the side wall 51b. Therefore, stepped gate structures of different sizes are obtained.

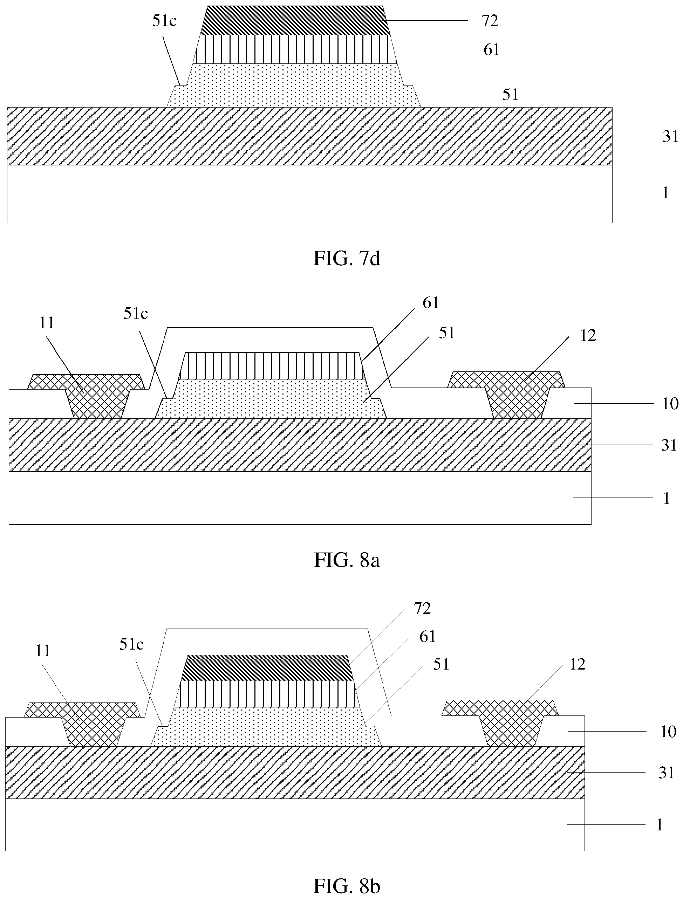

FIG. 7d shows an example of a schematic sectional view of a gate structure of another field effect transistor according to an embodiment of this application. Refer to FIG. 7d. In another embodiment of this application, after the step surface 51c is prepared, reservation of a second hard mask pattern 72 is further included. That is, the gate structure further includes a hard mask located on the metal gate 61. An orthographic projection of the hard mask on the channel layer 31 falls within a region in which the orthographic projection of the metal gate 61 on the channel layer 31 is located.

FIG. 8a to FIG. 8d show an example of a schematic sectional view of a field effect transistor according to an embodiment of this application. Refer to FIG. 8a to FIG. 8d. In this embodiment of this application, the field effect transistor may include a channel layer 31 located on a substrate 1, a control gate 51 located on the channel layer 31, a metal gate 61 located on the control gate 51, a passivation layer 10 located on the metal gate 61 and covering the control gate 51 and the metal gate 61, and a source 11 and a drain 12 located on the channel layer 31. The source 11 and the drain 12 are respectively located on two sides of the control gate 51. The control gate 51 has a top surface 51a and a side wall 51b connected to the top surface 51a. The side wall 51b has a step surface 51c parallel to the top surface 51a. An orthographic projection of the metal gate 61 on the substrate 1 falls within a region in which an orthographic projection of the top surface 51a on the substrate 1 is located.

The field effect transistor provided in this embodiment of this application is prepared by using the foregoing preparation method. The step surface 51c used to block a channel between side walls is formed on the side wall 51b of the control gate 51. The step surface 51c formed through inward shrinkage of the side wall 51b of the control gate 51 may improve electrical leakage between the side walls of the metal gate 61 and the control electrode 51. In comparison with a gate structure in the conventional technology in which a step surface used to block a channel between side walls is located on an interface between a control gate and a metal gate, in a process of forming the gate structure provided in this application, the step surface 51c is controlled to be located on the side wall 51b of the control gate 51, and patterns of the control electrode 51 and the metal gate 61 may be formed by using a single mask patterning process, so that process complexity and industrial costs are reduced. In addition, dry etching may be used in a process of forming the step surface 51c, so that etching damage is reduced.

In addition, because a problem-resolving principle of the field effect transistor is similar to that of the foregoing gate structure of the field effect transistor, for implementation of the field effect transistor, refer to implementation of the foregoing gate structure of the field effect transistor, and repeated parts are not described again.

It may be understood that specific implementations of the source 11 and the drain 12 are not limited in this application, and the source 11 and the drain 12 may be any structure capable of implementing functions of the field effect transistor. The source 11 and the drain 12 are respectively configured to be connected to an external circuit. The gate structure is configured to control connection and disconnection of a channel. When the gate structure controls the channel to be connected, the field effect transistor is conducted, and the circuit connected to the source 11 and the drain 12 may be connected. When the gate structure controls the channel to be disconnected, the field effect transistor is cut off, and the circuit connected to the source 11 and the drain 12 is disconnected.

For example, the source 11 and the drain 12 may be made of a metal material disposed at a same layer. In this way, the source 11 and the drain 12 may be formed by etching a same conducting layer, so that process steps and production costs may be reduced. In specific implementation, the source 11 and the drain 12 may be made of metal, and the source 11 and the drain 12 are electrically connected to the channel layer 31 separately.

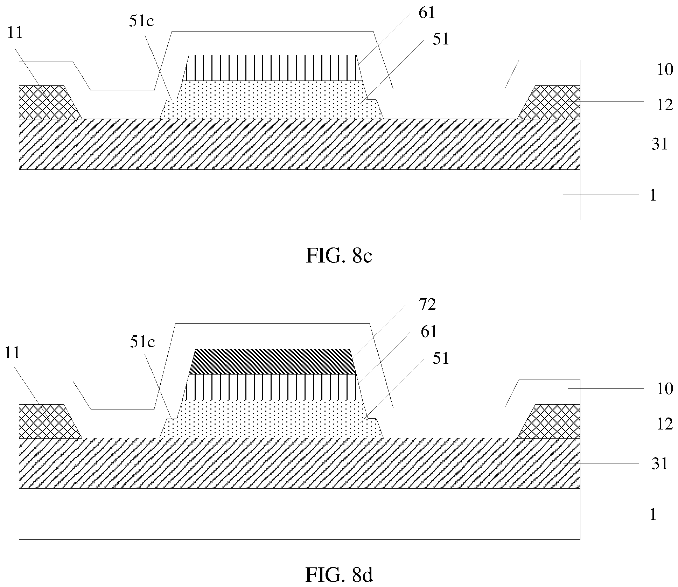

Refer to FIG. 8a and FIG. 8b. The source 11 and the drain 12 may be formed after the passivation layer 10. Refer to FIG. 8c and FIG. 8d. The source 11 and the drain 12 may alternatively be formed before the passivation layer 10. This is not limited herein.

An embodiment of this application further provides an electronic circuit. The electronic circuit may include a circuit board and the field effect transistor according to any one of the foregoing embodiments provided in this application. The field effect transistor is disposed on the circuit board. A problem-resolving principle of the electronic circuit is similar to that of the foregoing field effect transistor. Therefore, for implementation of the electronic circuit, refer to implementation of the foregoing field effect transistor, and repeated content is not described again.

It is clear that a person skilled in the art may make various modifications and variations to this application without departing from the spirit and scope of this application. This application is intended to cover these modifications and variations of this application provided that they fall within the scope of protection defined by the following claims and their equivalent technologies.

## Claims

1. A field effect transistor, comprising:
a channel layer, located on a substrate;
a control gate, located on the channel layer, wherein the control gate has a top surface and a side wall connected to the top surface, and the side wall has a step surface parallel to the top surface;
a metal gate, located on the top surface of the control gate, wherein an orthographic projection of the metal gate on the substrate falls within a region in which an orthographic projection of the top surface on the substrate is located;
a passivation layer, located on the metal gate and covering the control gate and the metal gate; and
a source and a drain, located on the channel layer, wherein the source and the drain are respectively located on two sides of the control gate.

2. The field effect transistor according to claim 1, wherein a width of the step surface is greater than 50 nm.

3. The field effect transistor according to claim 1 or 2, wherein a ratio of a height of the step surface to a thickness of the control gate ranges from 0 to 1.

4. The field effect transistor according to any one of claims 1 to 3, further comprising a hard mask, located between the metal gate and the passivation layer, wherein an orthographic projection of the hard mask on the substrate falls within a region in which the orthographic projection of the metal gate on the substrate is located.

5. An electronic circuit, comprising a circuit board and the field effect transistor that is disposed on the circuit board according to any one of claims 1 to 4.

6. A method for preparing a field effect transistor, comprising:
sequentially forming a channel layer, a control gate layer, a metal gate layer, a hard mask layer, and a photoresist layer on a substrate;
patterning the photoresist layer by using a mask, to form a first photoresist mask pattern;
performing dry etching on the hard mask layer under occlusion of the first photoresist mask pattern, to form a first hard mask pattern;
performing size shrinkage treatment on the first photoresist mask pattern, to form a second photoresist mask pattern, wherein a part, exposing the first hard mask pattern, of the second photoresist mask pattern forms a step surface; and
sequentially performing dry etching on the first hard mask pattern, the metal gate layer, and the control gate layer under occlusion of the second photoresist mask pattern, to form a second hard mask pattern, a metal gate, and a control gate, wherein orthographic projections of the second hard mask pattern and the metal gate on the substrate fall within a region in which an orthographic projection of a top surface of the control gate on the substrate is located, and in a dry etching process, the step surface extends downward and stops on a side wall of the control gate.

7. The preparation method according to claim 6, wherein the performing size shrinkage treatment on the first photoresist mask pattern specifically comprises:
performing secondary patterning on the first photoresist mask pattern by using the mask, or performing ashing treatment on the first photoresist mask pattern.

8. The preparation method according to claim 6 or 7, wherein a thickness of the second photoresist mask pattern is greater than 0.1 µm.

9. The preparation method according to any one of claims 6 to 8, wherein a width of the step surface is greater than 50 nm.

10. The preparation method according to any one of claims 6 to 9, wherein a ratio of a height of the step surface to a thickness of the control gate ranges from 0 to 1.

11. The preparation method according to any one of claims 6 to 10, further comprising: removing the second photoresist mask pattern and the second hard mask pattern.

12. The preparation method according to any one of claims 6 to 11, wherein when dry etching is performed on the hard mask layer to form the first hard mask pattern, the preparation method further comprises: performing dry etching on the metal gate layer.
